# EUROPÄISCHE PATENTSCHRIFT

(11) **EP 0 956 747 B1**
(45) Veröffentlichungstag und Bekanntmachung des Hinweises auf die Patenterteilung: **04.10.2001**
(21) Anmeldenummer: 97916344.1
(22) Anmeldetag: 12.03.1997
(51) Int. Cl.: H05K 1/02, H05K 3/46

(54) **LEITERPLATTE FÜR ELEKTRISCHE GERÄTE MIT HF-KOMPONENTEN, INSBESONDERE FÜR MOBILE FUNK-TELEKOMMUNIKATIONSGERÄTE**
CIRCUIT BOARD FOR ELECTRICAL APPARATUS WITH HF COMPONENTS, PARTICULARLY FOR MOBILE RADIOCOMMUNICATIONS EQUIPMENT
CARTE DE CIRCUITS POUR APPAREILS ELECTRIQUES A COMPOSANTS HF, NOTAMMENT POUR APPAREILS DE RADIOTELECOMMUNICATIONS MOBILES

(43) Veröffentlichungstag der Anmeldung: 17.11.1999
(73) Patentinhaber: SIEMENS AKTIENGESELLSCHAFT, 80333 München (DE)
(72) Erfinder: BUSCH, Georg, D-48683 Ahaus (DE)
(86) Internationale Anmeldenummer: DE9700490
(87) Internationale Veröffentlichungsnummer: WO9841066

(56) Entgegenhaltungen:
- US-A- 5 568 107
- N. CHANDLER ET AL.: "Ultra-fine feature printed circuits and multi-chip modules" GEC JOURNAL OF RESEARCH (INCORPORATING MARCONI.REVIEW.), Bd. 11, Nr. 2, 1994, GREAT BADDOW CHEMSFORD GB, Seiten 90-98, XP000454474
- C. BOYKO ET AL.: "Film redistribution layer technology" PROCEEDINGS OF THE 43RD ELECTRONIC COMPONENTS & TECHNOLOGY CONFERENCE, 1-4 JUNE 1993, ORLANDO, FL, US, 1993, IEEE, Seiten 302-305, XP000380028
- "Formation of surface laminar circuit on printed circuit board with plated through holes" IBM TECHNICAL DISCLOSURE BULLETIN., Bd. 36, Nr. 10, Oktober 1993, NEW YORK US, Seite 511 XP000412466
- K. R. BROOME: "A low cost, multi-layer FR4 circuit board for the RF and microwave circuits in a fixed wireless access residential transceiver unit" IEE COLLOQUIUM ON RF & MICROWAVE CIRCUITS FOR COMMERCIAL WIRELESS APPLICATIONS, LONDON, UK, 13 FEBRUAR 1997, 1997, IEE, LONDON, UK, Seiten 5/1-5/6, XP002046384

## Beschreibung

Die Erfindung bezieht sich auf eine Leiterplatte für elektrische Geräte mit HF-Komponenten, insbesondere für mobile Funk-Telekommunikationsgeräte, gemäß dem Oberbegriff des Patentanspruches 1.

Bei elektrischen Geräten mit Hochfrequenzkomponenten bzw. Hochfrequenzgeräteteilen (HF-Komponente; HF-Geräteteile) müssen diese HF-Komponenten von den Nicht-HF-Komponenten (z.B. NF-Komponenten) wegen auftretenden Wechselbeziehungen zwischen den genannten Komponenten [(1): die HF-Signale beeinflussen das NF-Verhalten der NF-Komponenten, wenn diese zu dicht an die HF-Komponenten plaziert sind; (2): durch zu nah an den HF-Komponenten plazierte NF-Komponenten werden die HF-Komponenten bezüglich der HF-Parametereinstellung beeinflußt] separiert bzw. vor gegenseitiger Beeinflussung geschützt werden. Ein typischer Ort, wo HF-Komponenten (HF-Schaltungen mit HF-Verdrahtungen und HF-Bauelementen) als auch Nicht-HF-Komponenten (Nicht-HF-Schaltungen mit Nicht-HF-Verdrahtungen und Nicht-HF-Bauelementen) dicht gedrängt angeordnet sind, ist die Leiterplatte oder elektronische Flachbaugruppe der elektrischen Geräte. Darüber hinaus wird die störende Wechselbeziehung zwischen den Komponenten bei kleinen elektrischen Geräten mit kleinen Leiterplatten verschärft. Auf der anderen Seite steigt die Nachfrage nach immer kleineren kompakteren elektrischen Geräten. Dies ist insbesondere dort der Fall, wo die miniaturisierten Geräte tragbar sind - von dem Benutzer also nahezu überall (an jeden geografischen Ort) mitgenommen werden können. Solche kleinen tragbaren Geräte sind beispielsweise mobile Funk-Telekommunikätionsgeräte.

Aus der Vielzahl von für diverse Zwecke zur Nachrichtenübertragung - wie z.B. die Übertragung von Sprach-, Paket- und/ oder Bilddaten - verwendeten (mobilen) Funk-Telekommunikationsgeräte - wie z.B. DECT-Telekommunikationsgeräte, GSM-Telekommunikationsgeräte, PHS-Telekommunikationsgeräte, "IS-95"-Telekommunikationsgeräte und sonstige auf reine oder hybride Übertragungsverfahren der Basisübertragungsverfahren FDMA, TDMA, CDMA (z.B. das DS-CDMA-Verfahren bzw. das JD-CDMA-Verfahren) basierende Telekommunikationsgeräte - bei denen das vorstehend geschilderte Problemfeld "Forderung nach Miniaturisierung einerseits und Vermeidung der störenden Wechselbeziehung zwischen HF-Komponenten und NF-Komponenten andererseits" im Zusammenhang mit der Forderung nach immer preisgünstigeren Geräten (Stw.: Massenprodukt) exemplarisch auftritt, werden nachfolgend stellvertretend für alle genannten Geräte die sich hieraus ergebenden Auswirkungen am Beispiel eines DECT-Mobilteils dargestellt und erläutert.

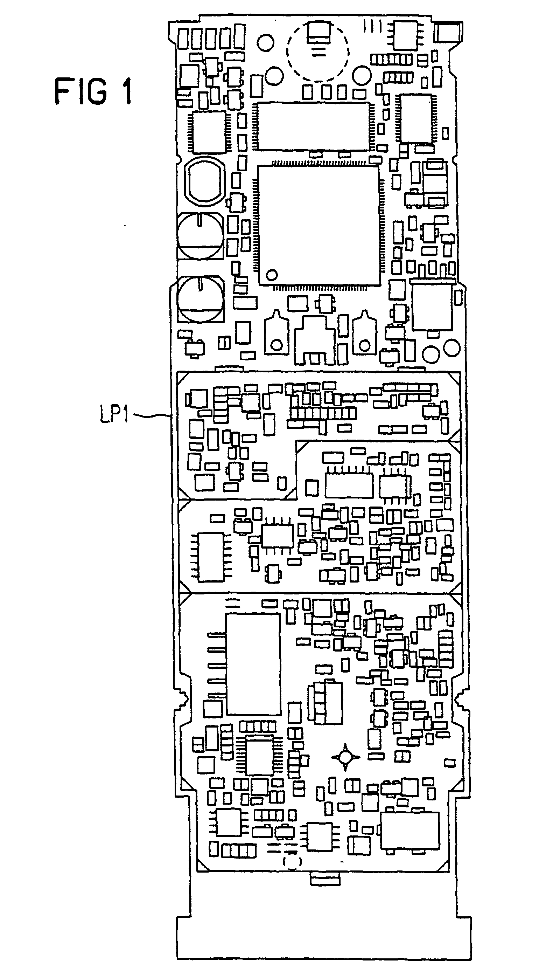

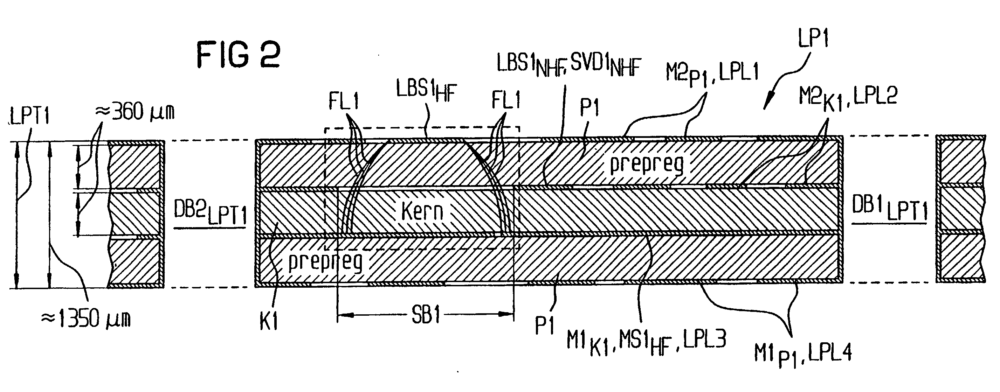

FIGUR 1 zeigt eine in dem Siemens DECT-Mobilteil "GIGASET 1000 S,C" verwendete, aus fertigungstechnischen Gründen vorzugsweise einseitig mit Bauelementen bestückte erste Leiterplatte LP1. Die Leiterplatte LP1 weist gemäß der Querschnittsdarstellung in FIGUR 2 einen mehrschichtigen, aus vier Leiterplattenlagen LPL1...LPL4 bestehenden ersten Leiterplattenträger LPT1 mit einer ca. 1.350 µm großen Dicke auf, der vorzugsweise nach dem bekannten Hybrid-Masslam-Verfahren aufgebaut ist. Der Leiterplattenträger LPT1 enthält danach einen ersten Kern K1 von ca. 360 µm Dicke mit einer auf der Unterseite des Kerns K1 angeordneten, vorzugsweise aus Kupfer hergestellten, als erste HF-Masseschicht MS1_{HF} ausgebildeten ersten Metallschicht M1_{K1} (dritte Leiterplattenlage LPL3) und einer auf der Oberseite des Kerns K1 angeordneten, vorzugsweise aus Kupfer hergestellten zweiten Metallschicht M2_{K1} (zweite Leiterplattenlage LPL2). Auf der Metallschicht M1_{K1}, M2_{K1} ist jeweils eine erste "Prepreg"-Schicht P1 von jeweils ca. 360 µm Dicke angeordnet. Als "Prepreg"-Schichten bezeichnet man glasfaserverstärkte Epoxy-Schichten. Die auf der Metallschicht M1_{K1} angeordnete "Prepreg"-Schicht P1 weist auf der der Metallschicht M1_{K1} gegenüberliegenden Seite eine vorzugsweise aus Kupfer hergestellte dritte Metallschicht M1_{P1} (vierte Leiterplattenlage LPL4) und auf der der Metallschicht M2_{K1} gegenüberliegenden Seite eine vorzugsweise aus Kupfer hergestellte vierte Metallschicht M2_{P1} (erste Leiterplattenlage LPL1) auf. In der ersten Leiterplattenlage LPL1 ist z.B. eine kritische erste HF-Leiterbahnstruktur LBS1_{HF} angeordnet, während in der zweiten Leiterplattenlage LPL2 z.B. eine erste Nicht-HF-Leiterbahnstruktur LBS1_{NHF} und/oder eine erste Nicht-HF-Schaltungsverdrahtung SVD1_{NHF} vorgesehen ist. Um die HF-Leiterbahnstruktur LBS1_{HF} in bezug auf die HF-Masseschicht MS_{HF} in der dritten Leiterplattenlage LPL3 vor Beeinflussung durch die Nicht-HF-Leiterbahnstruktur LBS1_{NHF} und/oder eine erste Nicht-HF-Schaltungsverdrahtung SVD1_{NHF} zu schützen, ist in der zweiten Leiterplattenlage LPL2 ein erste Feldlinien FL1 des HF-Signals großzügig umschließender erster Sperrbereich SB1 vorgesehen. Darüber hinaus sind in dem Leiterplattenträger LPT1 erste Durchbohrungen DB1_{LPT1} für HF-Verbindungen und Nicht-HF-Verbindungen zwischen der ersten Leiterplattenlage LPL1 und der vierten Leiterplattenlage LPL4 sowie zweite Durchbohrungen DB2_{LPT1} für den Anschluß von externen Baugruppen (z.B. Hörkapsel, Mikrofon etc.).

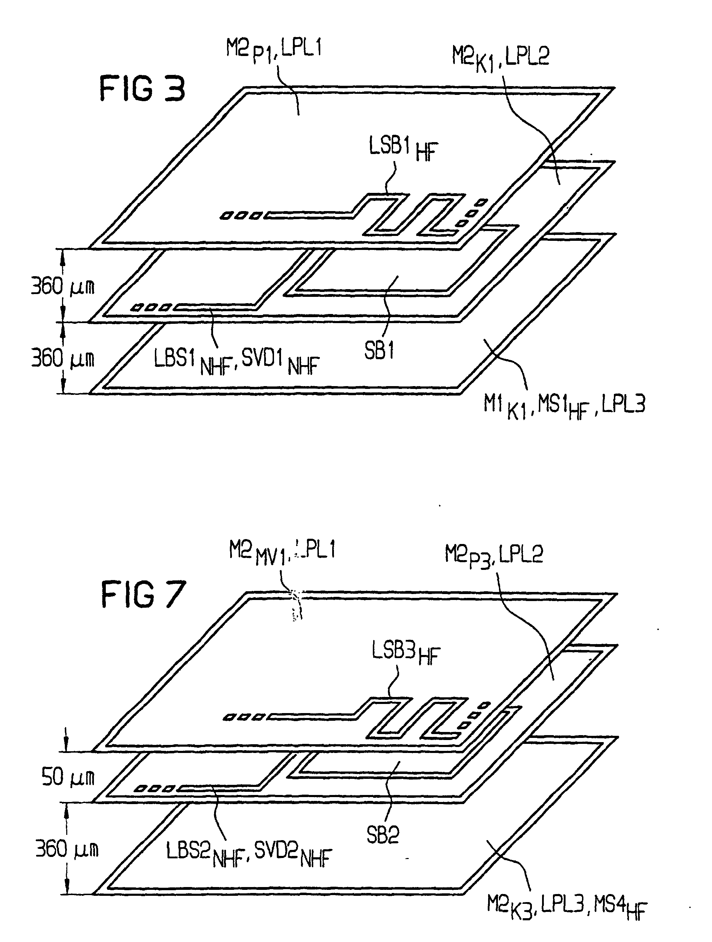

FIGUR 3 zeigt den in FIGUR 2 gestrichelt eingezeichneten Bereich vergrößert in einer dreidimensionalen Darstellung.

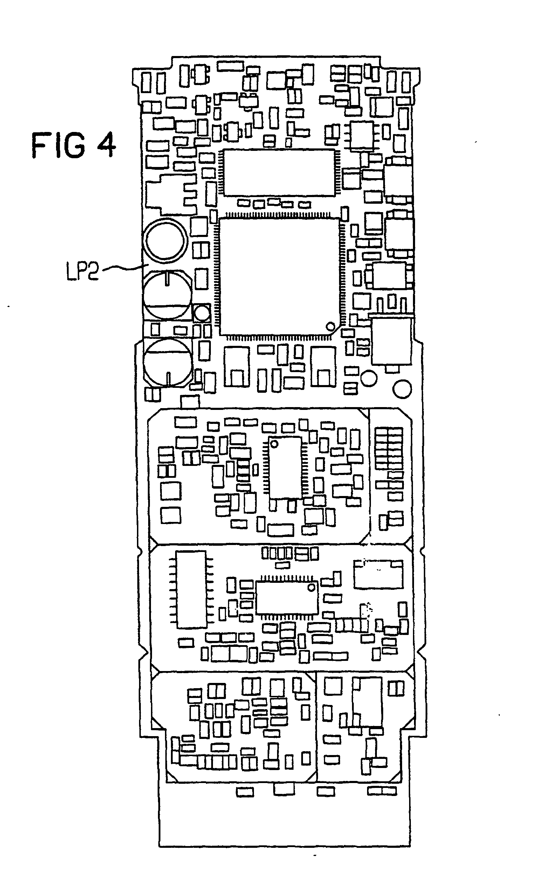

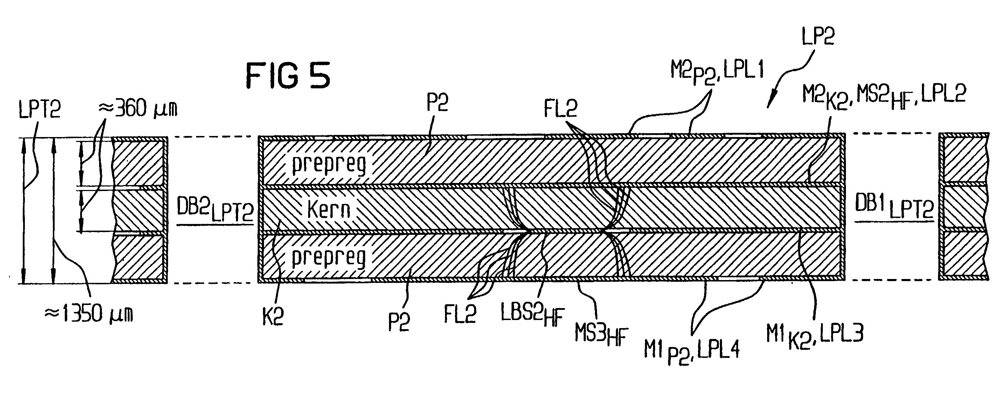

FIGUR 4 zeigt eine in dem Siemens DECT-Mobilteil "GIGASET 2000 S,C" verwendete, aus fertigungstechnischen Gründen wiederum vorzugsweise einseitig mit Bauelementen bestückte zweite Leiterplatte LP2. Die Leiterplatte LP2 weist gemäß der Querschnittsdarstellung in FIGUR 5 einen mehrschichtigen, wieder aus den vier Leiterplattenlagen LPL1...LPL4 bestehenden zweiten Leiterplattenträger LPT2 mit einer ca. 1.350 µm großen Dicke auf, der wieder vorzugsweise nach dem bekannten Hybrid-Masslam-Verfahren aufgebaut ist. Der Leiterplattenträger LPT2 enthält danach einen zweiten Kern K2 von ca. 360 µm Dicke mit einer auf der Unterseite des Kerns K2 angeordneten, vorzugsweise aus Kupfer hergestellten fünften Metallschicht M1_{K2} (dritte Leiterplattenlage LPL3) und einer auf der Oberseite des Kerns K2 angeordneten, vorzugsweise aus Kupfer hergestellten, als zweite HF-Masseschicht MS2_{HF} ausgebildeten sechsten Metallschicht M2_{K2} (zweite Leiterplattenlage LPL2). Auf der Metallschicht M1_{K2}, M2_{K2} ist jeweils eine zweite "Prepreg"-Schicht P2 von jeweils ca. 360 µm Dicke angeordnet. Die auf der Metallschicht M1_{K2} angeordnete "Prepreg"-Schicht P2 weist auf der der Metallschicht M1_{K2} gegenüberliegenden Seite eine vorzugsweise aus Kupfer hergestellte siebte Metallschicht M1_{P2} (vierte Leiterplattenlage LPL4) und auf der der Metallschicht M2_{K2} gegenüberliegenden Seite eine vorzugsweise aus Kupfer hergestellte achte Metallschicht M2_{P2} (erste Leiterplattenlage LPL1) auf. In den Leiterplattenlagen LPL2...LPL4 ist eine bekannte Tri-Plate-Struktur angeordnet. Diese Struktur besteht aus einer kritischen zweiten HF-Leiterbahnstruktur LBS2_{HF} in der dritten Leiterplattenlage LPL3, der HF-Masseschicht MS2_{HF} in der zweiten Leiterplattenlage LPL2 und einer für zweite Feldlinien FL2 des HF-Signals großzügig bemessenen dritten HF-Masseschicht MS3_{HF} in der vierten Leiterplattenlage LPL4. Darüber hinaus sind in dem Leiterplattenträger LPT2 wieder erste Durchbohrungen DB1_{LPT2} für die HF-Verbindungen und Nicht-HF-Verbindungen zwischen der ersten Leiterplattenlage LPL1 und der vierten Leiterplattenlage LPL4 sowie zweite Durchbohrungen DB2_{LPT2} für den Anschluß der externen Baugruppen (z.B. Hörkapsel, Mikrofon etc.).

Um die Leiterplatten LP1, LP2 in ihren Abmessungen zu verkleinern und damit - wie eingangs erläutert - kompaktere DECT-Mobilteile herstellen zu können, ist es bekannt, die Leiterplatten beidseitig zu bestücken. Dies erfordert aber einen größeren fertigungstechnischen Aufwand.

Bei der Leiterplattenkonzeption von elektrischen Geräten ohne HF-Komponenten ist es bekannt, um die vorstehende erwähnte Miniaturisierung von elektrischen Geräten voranzutreiben, die bekannte "Mikro Via"-Technologie (MV-Technologie) zu verwenden. Mit "Micro Via's" werden in der Leiterplattentechnik Durchkontaktierungen auf Leiterplatten in der Mikrometer-Größenordnung wie unten engegeben, bezeichnet. Die MV-Technologie ist eine Alternative zur ebenfalls bekannten mechanischen Sackloch-Durchkontaktierung. Die MV-Technologie ist eine Verbindungstechnologie zur kostengünstigen Herstellung von Leiterplatten ohne HF-Schaltungen und HF-Leiterbahnstrukturen. Die Kostenersparnis ergibt sich dadurch, daß neben den mechanischen Sacklochbohrungen, Einlauf-, und Auslaufmaterial auch das Entgraten der Bohrungen entfällt. Zur Zeit sind mehrere Fertigungsverfahren für die Herstellung von z.B. großflächigen "Mikro Via"-Schichten bekannt. Diese Verfahren sind das "Sequential Built Up"-Verfahren (SBU-Verfahren), das "Silver Bump"-Verfahren (SB-Verfahren), das Plasmaätzverfahren, das Laserbohren mit einem CO₂-Laser und das Laserbohren mit einem YAG-Laser. Für einen Großserieneinsatz kommen aus heutiger Sicht wegen des Kostenaspekts (Wirtschaftlichkeit) wahrscheinlich nur die ersten beiden Fertigungsverfahren in Betracht. Die mit der Technologie erstellten "Mikro Via's" (Durchkontaktierungen) haben beispielsweise einen Durchmesser von 50 bis 150 µm und erfordern z.B. Lötaugen im Bereich zwischen 0,12 und 0,35 mm Durchmesser. Der "Mikro Via"-Durchmeser ist wiederum abhängig von dem Abstand der "Mikro Via"-Schicht ("Mikro Via"-Lage) zur nächstliegenden Schicht (Lage) und muß Durchmesser/Lagenabstand > 1 sein. In Kombination mit der Feinstleitertechnologie mit Leiterbahnbreiten von 50 µm erreicht man höchste Verdrahtungsdichten.

Die Größe einer Leiterplatte wird bei den alternativ zur MV-Technologie bekannten Standard-Technologien (z.B. Sackloch-Durchkontaktierungen) erheblich durch den Platzbedarf der Durchkontaktierungen und durch die Leiterbahnstruktur, die auf der Bauteilseite der Leiterplatte liegen, bestimmt. Da bei der MV-Technologie die Möglichkeit besteht, direkt im "Pad" der Bauteile zur ersten Innenlage "abzutauchen", fällt der Platzbedarf für Durchkontaktierungen und Leiterbahnstrukturen nur noch wenig ins Gewicht. Bauteile können, sofern die HF-Problematik keine Rolle spielt, so eng wie es aus fertigungstechnischer Sicht erlaubt ist, nebeneinander plaziert werden. Die Leiterplattengröße wird bei der MV-Technologie unter der vorstehenden Prämisse fast ausschließlich durch die Anzahl und Bauform der verwendeten Bauelemente (Bauteile) bestimmt.

Die der Erfindung zugrundeliegende Aufgabe besteht darin, die Packungsdichte von elektronischen Schaltungen und Leiterbahnstrukturen auf Leiterplatten für elektrische Geräte mit HF-Komponenten, insbesondere für mobile Funk-Telekommunikationsgeräte zu erhöhen und dadurch die Abmessungen der Leiterplatte zu verkleinern.

Diese Aufgabe wird durch die im Patentanspruch 1 angegebenen Merkmale gelöst.

Die der Erfindung zugrundeliegende Idee besteht darin, auf einem Leiterplattenträger ein- oder beidseitig eine "Mikro Via"-Schicht aufzubringen, auf dieser "Mikro Via"-Schicht die gerätespezifischen Schaltungen mit Schaltungsverdrahtungen und Bauelementen sowie Leiterbahnstrukturen (z.B. HF-Schaltungen mit HF-Schaltungsverdrahtungen und HF-Bauelementen sowie HF-Leiterbahnstrukturen bzw. Nicht-HF-Schaltungen mit Nicht-HF-Schaltungsverdrahtungen und Nicht-HF-Bauelementen und Nicht-HF-Leiterbahnstrukturen für die in den Ansprüchen 10 bis 14 angegebenen Telekommunikationsgeräte) zumindest teilflächig aufzubringen und die HF-Schaltungen und HF-Leiterbahnstrukturen in bezug auf eine HF-Masseschicht des Leiterplattenträgers durch Sperrbereiche, sogenannte Fenster, die in einer unmittelbar unter der "Mikro Via"-Schicht liegenden Trägerschicht des Leiterplattenträgers angeordnet sind, vor störenden die jeweils einzustellenden HF-Parameter der HF-Schaltungen bzw. HF-Leiterbahnstrukturen beeinträchtigenden Einflüssen (z.B. vor den ebenfalls auf der unmittelbar unter der "Mikro Via"-Schicht liegenden Trägerschicht des Leiterplattenträgers angeordneten Nicht-HF-Leiterbahnstrukturen und/oder Nicht-HF-Schaltungsverdrahtungen) zu schützen.

Die vorstehend vorgestellte Vorgehensweise für einen Leiterplattenaufbau ist auch dann gültig bzw. ist auch dann anwendbar, wenn - im Unterschied zu den vorstehenden Ausführungen - einerseits die HF-Schaltungsverdrahtungen der HF-Schaltungen und HF-Leiterbahnstrukturen auf der unmittelbar unter der "Mikro Via"-Schicht liegenden Trägerschicht des Leiterplattenträgers und andererseits die Sperrbereiche sowie die HF-Bauelemente der HF-Schaltungen, die Nicht-HF-Leiterbahnstrukturen und/oder die Nicht-HF-Schaltungen mit den Schaltungsverdrahtungen und Bauelementen auf der "Mikro Via"-Schicht angeordnet sind. Darüber hinaus ist auch eine Kombination der beiden Vorgehensweisen möglich.

Bei der Verwendung der "Mikro Via"-Technologie und der Fenstertechnik muß man es für ein vorgegebenes Packungsvolumen an Schaltungen und Leiterbahnstrukturen auf der Leiterplatte in Kauf nehmen, daß die Anzahl an Leiterplattenlagen gegenüber einer Technologie ohne "Mikro Via"-Technologie und der Fenstertechnik erhöht wird. Die Anzahl der Leiterplattenlagen kann jedoch gegenüber einer Technologie ohne "Mikro Via"-Technologie und der Fenstertechnik nur dann unverändert gehalten werden, wenn entgegen der der Erfindung zugrundeliegenden Aufgabenstellung die Packungsdichte verkleinert wird und somit die beabsichtigte Verkleinerung (Miniaturisierung) des elektrischen Gerätes nicht erreicht wird.

Wird eine Leiterplatte für elektrische Geräte mit HF-Komponenten, insbesondere für mobile Funk-Telekommunikationsgeräte, jedoch nach der vorgeschlagenen Vorgehensweise aufgebaut, so ist der für die Unterbringung der gerätespezifischen Schaltungen und Leiterbahnstrukturen auf der Leiterplatte benötigte Platz gegenüber herkömmlich aufgebauten Leiterplatten signifikant kleiner.

Die weitere Vorgehensweise gemäß Anspruch 2 bringt den Vorteil, daß - wenn der Abstand zwischen der "Mikro Via"-Schicht und der unmittelbar unter der "Mikro Via"-Schicht liegenden Trägerschicht des Leiterplattenträgers in einer Größenordnung liegt, der für das kostengünstige Herstellen einer "Mikro Via"-Schicht nach dem bekannten "Sequential Built Up"-Verfahren (SBU-Verfahren) erforderlich ist - zusätzlich zum kleineren Leiterplattenaufbau wegen der höheren Packungsdichte die Herstellungskosten der Leiterplatte drastisch gesenkt werden.

Der annähernd gleiche Effekt (Vorteil) tritt bei der Vorgehensweise gemäß der Ansprüche 3 und 4 ein.

Die Weiterbildung der Erfindung gemäß Anspruch 5 ermöglicht beispielsweise aufgrund der Bedingung "Lochdurchmesser eines "Mikro Via's" zu Abstand zwischen der "Mikro Via"-Schicht und der unmittelbar unter der "Mikro Via"-Schicht liegenden Trägerschicht des Leiterplattenträgers" bei typischen Lochdurchmessern zwischen 50 µm und 150 µm ein Verhältnis von Lochdurchmesser zu Lagenabstand größer als 1 und erfordert Lötaugendurchmesser zwischen 0,12 mm und 0,35 mm.

Durch die Weiterbildung der Erfindung gemäß Anspruch 6 ist eine gegenüber der Lehre nach Anspruch 1 weitere Verkleinerung des Leiterplattenaufbaus möglich, weil durch die HF-Schaltung, die zusätzlich auf der die ersten Löcher ("Standard Via's") abdeckenden "Mikro Via"-Schicht aufgebracht werden kann, die Packungsdichte weiter erhöht werden kann.

Die Weiterbildung der Erfindung gemäß Anspruch 7 stellt sicher, daß es bei der Abdeckung der ersten Löcher in der "Mikro Via"-Schicht wegen des durch die Abdeckung erzeugten Mikroklimas in den Löchern nicht zu einem Ausblasen (Explosion) kommt.

Vorteilhafte Weiterbildungen der Erfindung sind in den Unteransprüchen angegeben.

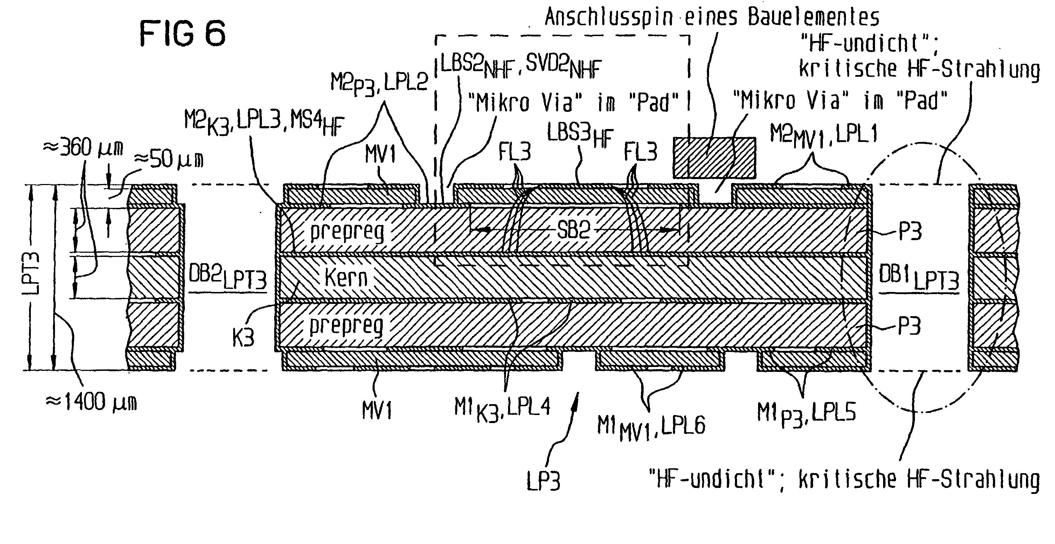

Ein Ausführungsbeispiel der Erfindung wird anhand der FIGUREN 6 bis 10 erläutert.

FIGUR 6 zeigt eine gegenüber den Leiterplatten LP1, LP2 durch die Verwendung der MV-Technologie in Verbindung mit der darauf abgestimmten Fenstertechnik modifizierte dritte Leiterplatte LP3, die aus fertigungstechnischen Gründen vorzugsweise wieder einseitig mit Bauelementen bestückt ist. Eine beidseitige Bestückung ist aber auch möglich. Dadurch würden die Abmessungen der Leiterplatte LP3 noch kleiner. Die Leiterplatte LP3 mit einer Dicke von ca. 1400 µm weist gemäß der Querschnittsdarstellung in FIGUR 6 und gegenüber den Leiterplattenträgern LPT1, LTP2 mit den Leiterplattenlagen LPL1...LPL4 in den FIGUREN 2 und 5 einen mehrschichtigen, aus vier Leiterplattenlagen LPL2...LPL5 bestehenden dritten Leiterplattenträger LPT3 auf, der bezüglich der Leiterplattenlagen LPL2...LPL5 wieder vorzugsweise nach dem bekannten Hybrid-Masslam-Verfahren aufgebaut ist. Im Unterschied zu den Leiterplatten LP1, LP2 mit den Leiterplattenträgern LPT1, LPT2 ist auf der Außenschicht an der Oberseite des Leiterplattenträgers LPT3 und auf der Außenschicht an der Unterseite des Leiterplattenträgers LPT3 jeweils eine weitere nach der MV-Technologie aufgebaute Leiterplattenlage LPL1, LPL6 vorgesehen.

Der Leiterplattenträger LPT3 enthält einen dritten Kern K3 von ca. 360 µm Dicke mit einer auf der Unterseite des Kerns K3 angeordneten, vorzugsweise aus Kupfer hergestellten neunten Metallschicht M1_{K3} (vierte Leiterplattenlage LPL4) und einer auf der Oberseite des Kerns K3 angeordneten, vorzugsweise aus Kupfer hergestellten, als vierte HF-Masseschicht MS4_{HF} ausgebildeten zehnten Metallschicht M2_{K3} (dritte Leiterplattenlage LPL3). Auf der Metallschicht M1_{K3}, M2_{K3} ist jeweils eine dritte "Prepreg"-Schicht P3 von jeweils ca. 360 µm Dicke angeordnet. Die auf der Metallschicht M1_{K3} angeordnete "Prepreg"-Schicht P3 weist auf der der Metallschicht M1_{K3} gegenüberliegenden Seite eine vorzugsweise aus Kupfer hergestellte elfte Metallschicht M1_{P3} (fünfte Leiterplattenlage LPL5) und auf der der Metallschicht M2_{K3} gegenüberliegenden Seite eine vorzugsweise aus Kupfer hergestellte zwölfte Metallschicht M2_{P3} (zweite Leiterplattenlage LPL2) auf. Auf der Metallschicht M1_{P3}, M2_{P3} ist jeweils eine erste "Mikro Via"-Schicht MV1 von jeweils ca. 50 µm Dicke angeordnet. Die auf der Metallschicht M1_{P3} angeordnete "Mikro Via"-Schicht MV1 weist auf der der Metallschicht M1_{P3} gegenüberliegenden Seite eine vorzugsweise aus Kupfer hergestellte dreizehnte Metallschicht M1_{MV1} (sechste Leiterplattenlage LPL6) und auf der der Metallschicht M2_{P3} gegenüberliegenden Seite eine vorzugsweise aus Kupfer hergestellte vierzehnte Metallschicht M2_{MV1} (erste Leiterplattenlage LPL1) auf. In der ersten Leiterplattenlage LPL1 ist z.B. eine kritische dritte HF-Leiterbahnstruktur LBS3_{HF} angeordnet, während in der zweiten Leiterplattenlage LPL2 z.B. eine zweite Nicht-HF-Leiterbahnstruktur LBS2_{NHF} und/oder eine zweite Nicht-HF-Schaltungsverdrahtung SVD2_{NHF} vorgesehen ist. Um die HF-Leiterbahnstruktur LBS3_{HF} in bezug auf die HF-Masseschicht MS4_{HF} in der dritten Leiterplattenlage LPL3 vor Beeinflussung durch die Nicht-HF-Leiterbahnstruktur LBS2_{NHF} und/oder die Nicht-HF-Schaltungsverdrahtung SVD2_{NHF} zu schützen, ist in der zweiten Leiterplattenlage LPL2 ein dritte Feldlinien FL3 des HF-Signals großzügig umschließender zweiter Sperrbereich SB2 vorgesehen.

Die HF-Leiterbahnstruktur LBS3_{HF} kann alternativ oder zusätzlich auch in der zweiten Leiterplattenlage LPL2, der fünften Leiterplattenlage LPL5 und/oder der sechsten Leiterplattenlage LPL6 angeordnet sein. In dem letzten Fall müßte folgerichtig der Sperrbereich in der fünften Leiterplattenlage LPL5 liegen. In den beiden ersten Fällen würden die Sperrbereiche in der ersten Leiterplattenlage LPL1 bzw. in der sechsten Leiterplattenlage LPL6 liegen.

Darüber hinaus sind in dem Leiterplattenträger LPT3 erste Durchbohrungen DB1_{LPT3} für HF-Verbindungen und Nicht-HF-Verbindungen zwischen der ersten Leiterplattenlage LPL1 und der sechsten Leiterplattenlage LPL6 sowie zweite Durchbohrungen DB2_{LPT3} für den Anschluß von externen Baugruppen (z.B. Hörkapsel, Mikrofon etc.). Bleiben insbesondere die Durchbohrungen DB1_{LPT3} - wie dargestellt - offen, so entweicht aus diesen Bohrungen eine durch die HF-Schaltungen und HF-Leiterbahnstrukturen auf der Leiterplatte hervorgerufene HF-Strahlung (unerwünschter Effekt).

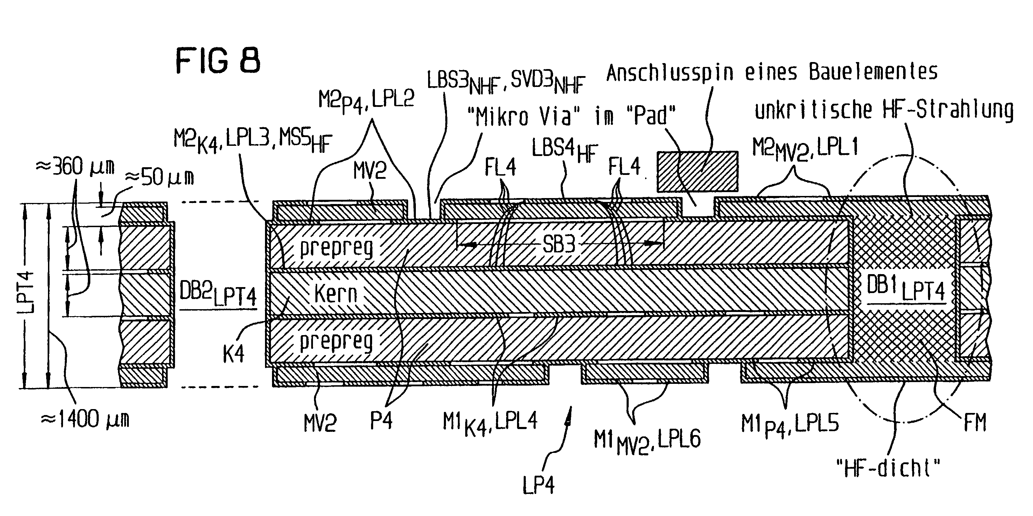

FIGUR 7 zeigt den in FIGUR 6 gestrichelt eingezeichneten Bereich vergrößert in einer dreidimensionalen Darstellung.

FIGUR 8 zeigt eine gegenüber der Leiterplatten LP3 in FIGUR 6 leicht modifizierte vierte Leiterplatte LP4, die aus fertigungstechnischen Gründen vorzugsweise wieder einseitig mit Bauelementen bestückt ist. Eine beidseitige Bestückung ist hier auch wieder möglich. Die Leiterplatte LP4 mit einer Dikke von ca. 1400 µm weist gemäß der Querschnittsdarstellung in FIGUR 8 und gegenüber dem Leiterplattenträger LPT3 in FIGUR 6 einen mehrschichtigen, wieder aus den vier Leiterplattenlagen LPL2...LPL5 bestehenden vierten Leiterplattenträger LPT4, der wieder vorzugsweise nach dem bekannten Hybrid-Masslam-Verfahren aufgebaut ist, und die zwei nach der MV-Technologie aufgebauten Leiterplattenlagen LPL1, LPL6 auf.

Die Leiterplattenlage LPL1 befindet sich auf der Außenschicht an der Oberseite des Leiterplattenträgers LPT4, während die Leiterplattenlage LPL6 sich auf der Außenschicht an der Unterseite des Leiterplattenträgers LPT4 befindet. Der Leiterplattenträger LPT4 enthält einen vierten Kern K4 von ca. 360 µm Dicke mit einer auf der Unterseite des Kerns K4 angeordneten, vorzugsweise aus Kupfer hergestellten fünfzehnten Metallschicht M1_{K4} (vierte Leiterplattenlage LPL4) und einer auf der Oberseite des Kerns K4 angeordneten, vorzugsweise aus Kupfer hergestellten, als fünfte HF-Masseschicht MS5_{HF} ausgebildeten sechzehnten Metallschicht M2_{K4} (dritte Leiterplattenlage LPL3). Auf der Metallschicht M1_{K4}, M2_{K4} ist jeweils eine vierte "Prepreg"-Schicht P4 von jeweils ca. 360 µm Dicke angeordnet. Die auf der Metallschicht M1_{K4} angeordnete "Prepreg"-Schicht P4 weist auf der der Metallschicht M1_{K4} gegenüberliegenden Seite eine vorzugsweise aus Kupfer hergestellte siebzehnte Metallschicht M1_{P4} (fünfte Leiterplattenlage LPL5) und auf der der Metallschicht M2_{K4} gegenüberliegenden Seite eine vorzugsweise aus Kupfer hergestellte achtzehnte Metallschicht M2_{P4} (zweite Leiterplattenlage LPL2) auf. Auf der Metallschicht M1_{P4}, M2_{P4} ist jeweils eine zweite "Mikro Via"-Schicht MV2 von jeweils ca. 50 µm Dicke angeordnet. Die auf der Metallschicht M1_{P4} angeordnete "Mikro Via"-Schicht MV2 weist auf der der Metallschicht M1_{P4} gegenüberliegenden Seite eine vorzugsweise aus Kupfer hergestellte neunzehnte Metallschicht M1_{MV2} (sechste Leiterplattenlage LPL6) und auf der der Metallschicht M2_{P4} gegenüberliegenden Seite eine vorzugsweise aus Kupfer hergestellte zwanzigste Metallschicht M2_{MV2} (erste Leiterplattenlage LPL1) auf. In der ersten Leiterplattenlage LPL1 ist z.B. eine kritische vierte HF-Leiterbahnstruktur LBS4_{HF} angeordnet, während in der zweiten Leiterplattenlage LPL2 z.B. eine dritte Nicht-HF-Leiterbahnstruktur LBS3_{NHF} und/oder eine dritte Nicht-HF-Schaltungsverdrahtung SVD3_{NHF} vorgesehen ist. Um die HF-Leiterbahnstruktur LBS4_{HF} in bezug auf die HF-Masseschicht MS5_{HF} in der dritten Leiterplattenlage LPL3 vor Beeinflussung durch die Nicht-HF-Leiterbahnstruktur LBS3_{NHF} und/oder die Nicht-HF-Schaltungsverdrahtung SVD3_{NHF} zu schützen, ist in der zweiten Leiterplattenlage LPL2 ein vierte Feldlinien FL4 des HF-Signals großzügig umschließender dritter Sperrbereich SB3 vorgesehen.

Die HF-Leiterbahnstruktur LBS4_{HF} kann wieder alternativ oder zusätzlich auch in der zweiten Leiterplattenlage LPL2, der fünften Leiterplattenlage LPL5 und/oder der sechsten Leiterplattenlage LPL6 angeordnet sein. In dem letzten Fall müßte folgerichtig der Sperrbereich in der fünften Leiterplattenlage LPL5 liegen. In den beiden ersten Fällen würden die Sperrbereiche in der ersten Leiterplattenlage LPL1 bzw. in der sechsten Leiterplattenlage LPL6 liegen.

Darüber hinaus sind in dem Leiterplattenträger LPT4 erste Durchbohrungen DB1_{LPT4} für HF-Verbindungen und Nicht-HF-Verbindungen zwischen der ersten Leiterplattenlage LPL1 und der sechsten Leiterplattenlage LPL6 sowie zweite Durchbohrungen DB2_{LPT4} für den Anschluß von externen Baugruppen (z.B. Hörkapsel, Mikrofon etc.). Im Unterschied zu den Verhältnissen in FIGUR 6 sind die Durchbohrungen DB1_{LPT4} - wie dargestellt - durch die "Mikro Via"-Schicht MV2 mit der Metallschicht M1_{Mv2} bzw. mit der Metallschicht M2_{MV2} geschlossen. Während auf der Metallschicht M2_{MV2} durch diese Maßnahme zusätzlicher Platz für HF-Schaltungen bzw. HF-Leiterbahnstrukturen geschaffen wird (weitere Erhöhung der Packungsdichte), werden auf der Metallschicht M1_{MV2} dadurch, daß diese als durchgehende Masseschicht ausgebildet ist, die Bohrungen "HF-dicht" gemacht, so daß aus diesem Teil der Bohrungsöffnung keine durch die HF-Schaltungen und HF-Leiterbahnstrukturen auf der Leiterplatte hervorgerufene HF-Strahlung mehr entweichen kann. Da über der anderen Bohrungsöffnung eine HF-Schaltung bzw. eine HF-Leiterbahnstruktur gelegt ist, ist die hieraus entweichende HF-Strahlung unkritisch.

Damit die auf diese Weise abgedeckte Bohrung DB_{LPT4} beim Abdecken durch das dadurch in der Bohrung entstehende Mikroklima nicht ausbläst, wird die Bohrung vorzugsweise mit einem Füllmaterial FM ausgefüllt.

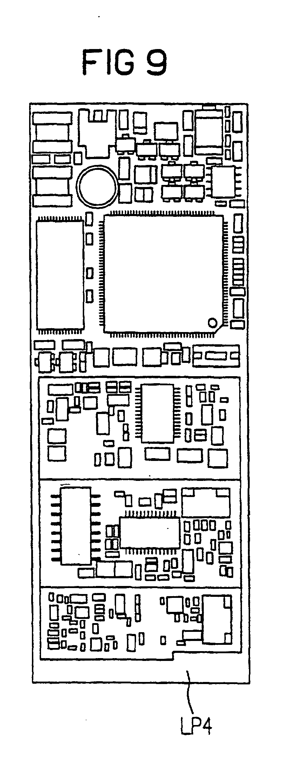

FIGUR 9 zeigt die auf diese Weise erreichbaren Abmaße der Leiterplatte LP4.

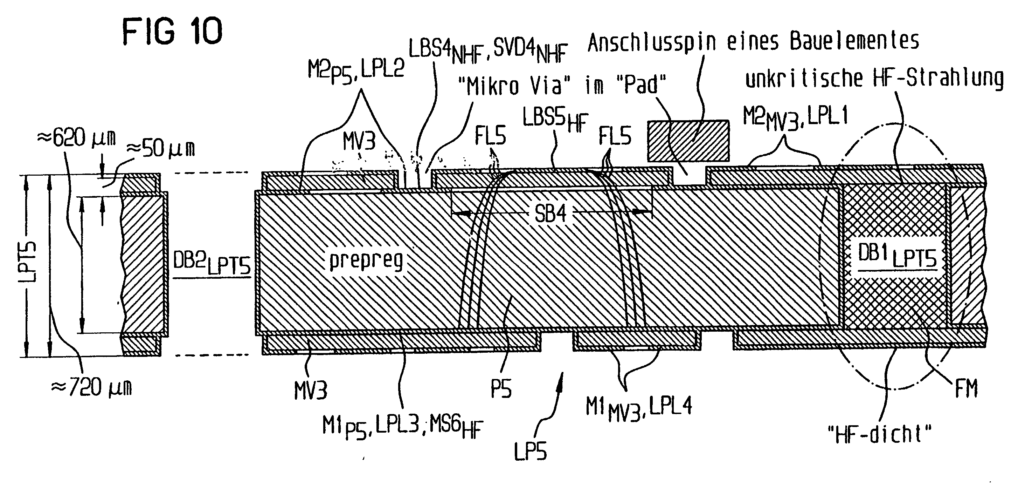

FIGUR 10 zeigt eine gegenüber der Leiterplatte LP3 in FIGUR 6 und der Leiterplatte LP4 in FIGUR 8 leicht modifizierte fünfte Leiterplatte LP5, die aus fertigungstechnischen Gründen vorzugsweise wieder einseitig mit Baüelementen bestückt ist. Eine beidseitige Bestückung ist hier auch wieder möglich. Die Leiterplatte LP5 weist gemäß der Querschnittsdarstellung in FIGUR 10 und gegenüber den mehrschichtigen, aus den sechs Leiterplattenlagen LPL1 ..LPL6 bestehenden dritten Leiterplattenträger LPT3 in FIGUR 6 und den vierten Leiterplattenträger LPT4 in FIGUR 8 einen mehrschichtigen, aus vier Leiterplattenlagen LPL1...LPL4 bestehenden fünften Leiterplattenträger LPT5 mit wiederum einer Dicke von ca. 1400 µm auf, der bezüglich der Leiterplattenlagen LPL2,.LPL3 wieder vorzugsweise nach dem bekannten Hybrid-Masslam-Verfahren aufgebaut ist, während die Leiterplattenlagen LPL1, LPL4 nach der MV-Technologie aufgebaut sind.

Der Leiterplattenträger LPT5 besteht im Unterschied zu den Leiterplattenträgern LPT3, LPT4 aus einer einzigen Trägerschicht. Dadurch ist eine Herstellungskostenreduzierung bezüglich des Leiterplattenträgeraufbaus möglich. Der Leiterplattenträger LPT5 enthält eine fünfte "Prepreg"-Schicht P5 von ca. 620 µm Dicke. Diese "Prepreg"-Schicht P5 weist auf der Unterseite der "Prepreg"-Schicht P5 eine vorzugsweise aus Kupfer hergestellte, als sechste HF-Masseschicht MS6_{HF} ausgebildete einundzwanzigste Metallschicht M1_{P5} (dritte Leiterplattenlage LPL3) und auf der Oberseite der "Prepreg"-Schicht P5 eine vorzugsweise aus Kupfer hergestellte zweiundzwanzigste Metallschicht M2_{P5} (zweite Leiterplattenlage LPL2) auf. Auf der Metallschicht M1_{P5}, M2_{P5} ist jeweils eine dritte "Mikro Via"-Schicht MV3 von jeweils ca. 50 µm Dicke angeordnet. Die auf der Metallschicht M1_{P5} angeordnete "Mikro Via"-Schicht MV3 weist auf der der Metallschicht M1_{P5} gegenüberliegenden Seite eine vorzugsweise aus Kupfer hergestellte dreiundzwanzigste Metallschicht M1_{MV3} (sechste Leiterplattenlage LPL4) und auf der der Metallschicht M2_{P5} gegenüberliegenden Seite eine vorzugsweise aus Kupfer hergestellte vierundzwanzigste Metallschicht M2_{MV3} (erste Leiterplattenlage LPL1) auf. In der ersten Leiterplattenlage LPL1 ist z. B. eine kritische fünfte HF-Leiterbahnstruktur LPS5_{HF} angeordnet, während in der zweiten Leiterplattenlage LBL2 z.B. eine vierte Nicht-HF-Leiterbahnstruktur LBS4_{NHF} und/oder eine vierte Nicht-HF-Schaltungsverdrahtung SVD4_{NHF} vorgesehen ist. Um die HF-Leiterbahnstruktur LBS5_{HF} in bezug auf die HF-Masseschicht MS6_{HF} in der dritten Leiterplattenlage LPL3 vor Beeinflussung durch die Nicht-HF-Leiterbahnstruktur LBS4_{NHF} und/oder die Nicht-HF-Schaltungsverdrahtung SVD4_{NHF} zu schützen, ist in der zweiten Leiterplattenlage LPL2 ein vierte Feldlinien FL5 des HF-Signals großzügig umschließender vierter Sperrbereich SB4 vorgesehen.

Die HF-Leiterbahnstruktur LBS4_{HF} kann wieder alternativ oder zusätzlich auch in der zweiten Leiterplattenlage LPL2, der dritten Leiterplattenlage LPL3 und/oder der vierten Leiterplattenlage LPL4 angeordnet sein. In dem letzten Fall müßte folgerichtig der Sperrbereich in der dritten Leiterplattenlage LPL3 liegen. In den beiden ersten Fällen würden die Sperrbereiche in der ersten Leiterplattenlage LPL1 bzw. in der vierten Leiterplattenlage LPL4 liegen.

Darüber hinaus sind in dem Leiterplattenträger LPT5 erste Durchbohrungen DB1_{LPT5} für HF-Verbindungen und Nicht-HF-Verbindungen zwischen der ersten Leiterplattenlage LPL1 und der vierten Leiterplattenlage LPL4 sowie zweite Durchbohrungen DB2_{LPT5} für den Anschluß von externen Baugruppen (z. B. Hörkapsel, Mikrofon etc.). Im Unterschied zu den Verhältnissen in FIGUR 6 und in Übereinstimmung zu den Verhältnissen in FIGUR 8 sind die Durchbohrungen DB1_{LPT5} - wie dargestellt - durch die "Mikro Via"-Schicht MV3 mit der Metallschicht M1_{MV3} bzw. mit der Metallschicht M2_{MV3} geschlossen. Während auf der Metallschicht M2_{MV3} durch diese Maßnahme zusätzlicher Platz für HF-Schaltungen bzw. HF-Leiterbahnstrukturen geschaffen wird (weitere Erhöhung der Packungsdichte), werden auf der Metallschicht M1_{MV3} dadurch, daß diese als durchgehende Masseschicht ausgebildet ist, die Bohrungen "HF-dicht" gemacht, so daß aus diesem Teil der Bohrungsöffnung keine durch die HF-Schaltungen und HF-Leiterbahnstrukturen auf der Leiterplatte hervorgerufene HF-Strahlung mehr entweichen kann. Da über der anderen Bohrungsöffnung eine HF-Schaltung bzw. eine HF-Leiterbahnstruktur gelegt ist, ist die hieraus entweichende HF-Strahlung unkritisch.

Damit die auf diese Weise abgedeckte Bohrung DB_{LPT4} beim Abdecken durch das dadurch in der Bohrung entstehende Mikroklima nicht ausbläst, wird die Bohrung vorzugsweise mit dem Füllmaterial FM ausgefüllt.

## Patentansprüche

1. Leiterplatte für elektrische Geräte mit HF-Komponenten, insbesondere für mobile Funk-Telekommunikationsgeräte, wobei HF-Schaltungen, Nicht-HF-Schaltungen, HF-Leiterbahnstrukturen und Nicht-HF-Leiterbahnstrukturen auf der Leiterplatte (LP3...LP5) angeordnet sind, mit folgenden Merkmalen:
a) ein Träger (LPT3...LPT5) mit einer ersten Außenschicht (LPL2) und einer zweiten Außenschicht (LPL3, LPL5) weist eine Vielzahl von die Außenschichten (LPL2, LPL3, LPL5) durchstoßenden Löchern (DB1_{LPT3...5}, DB2_{LPT3...5}) auf,
b) eine "Mikro Via"-Schicht (LPL1, LPL4, LPL6, MV1...MV3) ist mindestens auf einer Außenschicht (LPL2, LPL3, LPL5) der beiden Außenschichten (LPL2, LPL3, LPL5) zumindest teilflächig aufgebracht,
c) Sperrbereiche (SB2...SB4) für die Nicht-HF-Schaltungen und Nicht-HF-Leiterbahnstrukturen (LBS2_{NHF}...LBS4_{NHF}) sind auf der "Mikro Via"-Schicht (LPL1, LPL4, LPL6, MV1...MV3) und/oder auf der durch die "Mikro Via"-Schicht jeweils abgedeckten Außenschicht (LPL2, LPL3, LPL5) derart angeordnet, daß die HF-Eigenschaften (FL3...FL5) der in bezug auf eine HF-Masseschicht (LPL3, MS4_{HF}...MS6_{HF}) des Trägers (LPT3...LPT5) oberhalb und/oder unterhalb der Sperrbereiche (SB2...SB4) angeordneten HF-Schaltungen und HF-Leiterbahnstrukturen (LBS3_{HF}...LBS5_{HF}) geschützt sind,
d) auf der "Mikro Via"-Schicht (LPL1, LPL4, LPL6, MV1...MV3) sind bei bestückter Leiterplatte Bauelemente der HF-/NHF-Schaltungen angeordnet,
e) Schaltungsverdrahtungen (SVD2_{NHF}...SVD4_{NHF}) sind mindestens auf der "Mikro Via"-Schicht (LPL1, LPL4, LPL6, MV1...MV3) und/oder auf der durch die "Mikro Via"-Schicht (LPL1, LPL4, LPL6, MV1...MV3) jeweils abgedeckten Außenschicht (LPL2, LPL3, LPL5) angeordnet,
f) die Leiterbahnstrukturen (LBS2_{NHF} ...LBS4_{NHF}, LBS3_{HF}...LBS5_{HF}) sind mindestens auf der "Mikro Via"-Schicht (LPL1, LPL4, LPL6, MV1...MV3) und/oder auf der durch die "Mikro Via"-Schicht (LPL1, LPL4, LPL6, MV1...MV3) jeweils abgedeckten Außenschicht (LPL2, LPL3, LPL5) angeordnet.

2. Leiterplatte nach Anspruch 1, **dadurch gekennzeichnet, daß**
der Abstand zwischen der Außenschicht und der "Mikro Via"-Schicht so bemessen ist, **daß** die "Mikro Via"-Schicht mit dem "Sequential Built Up"-Verfahren (SBU-Verfahren) herstellbar ist.

3. Leiterplatte nach Anspruch 1, **dadurch gekennzeichnet, daß**
der Abstand zwischen der Außenschicht und der "Mikro Via"-Schicht so bemessen ist, **daß** die "Mikro Via"-Schicht durch Laserbohren mit einem CO₂-Laser herstellbar ist.

4. Leiterplatte nach Anspruch 1, **dadurch gekennzeichnet, daß**
der Abstand zwischen der Außenschicht und der "Mikro Via"-Schicht so bemessen ist, **daß** die "Mikro Via"-Schicht mit dem "Silver Bump"-Verfahren (SB-Verfahren) herstellbar ist.

5. Leiterplatte nach Anspruch 2, 3 oder 4, **dadurch gekennzeichnet, daß**
der Abstand zwischen der Außenschicht und der "Mikro Via"-Schicht 50 µm beträgt.

6. Leiterplatte nach einem der Ansprüche 1 bis 5, **dadurch gekennzeichnet, daß**
erste Löcher (DB1_{LPT4,5}) durch die "Mikro Via"-Schicht ohne die Sperrbereiche abgedeckt sind und **daß** auf der die ersten Löcher abdeckenden "Mikro Via"-Schicht die HF-Schaltung und/oder zur HF-Abschirmung eine metallische Schicht aufgebracht ist.

7. Leiterplatte nach Anspruch 6, **dadurch gekennzeichnet, daß**
die ersten Löcher mit einem Füllmaterial (FM) gefüllt sind.

8. Leiterplatte nach einem der Ansprüche 1 bis 7, **dadurch gekennzeichnet, daß**
der Träger ein Mehrschichtträger ist.

9. Leiterplatte nach Anspruch 8, **dadurch gekennzeichnet, daß**
der Mehrschichtträger nach dem Hybrid-Masslam-Verfahren aufgebaut ist.

10. Verwendung der Leiterplatte nach einem der Ansprüche 1 bis 9 in einem DECT-Telekommunikationsgerät.

11. Verwendung der Leiterplatte nach einem der Ansprüche 1 bis 9 in einem GSM-Telekommunikationsgerät.

12. Verwendung der Leiterplatte nach einem der Ansprüche 1 bis 9 in einem PHS-Telekommunikationsgerät.

13. Verwendung der Leiterplatte nach einem der Ansprüche 1 bis 9 in einem "IS-95"-Telekommunikationsgerät.

14. Verwendung der Leiterplatte nach einem der Ansprüche 1 bis 9 in einem auf einem reinen oder hybriden Übertragungsverfahren der Basisübertragungsverfahren FDMA, TDMA, CDMA basierenden Funk-Telekommunikationsgerät.

## Claims

1. Printed circuit board for electrical appliances having RF components, particularly for mobile radio telecommunication appliances, with RF circuits, non-RF circuits, RF conductor-track structures and non-RF conductor-track structures being arranged on the printed circuit board (LP3...LP5), having the following features:
a) a support (LPT3...LPT5) having a first outer layer (IPL2) and a second outer layer (LPL3, LPL5) has a multiplicity of holes (DB1_{LPT3...5}, DB2_{LPT3...5}) which penetrate the outer layers (LPL2, LPL3, LPL5),
b) a "micro via" layer (LPL1, LPL4, LPL6, MV1...MV3) is applied to at least part of the surface of at least one outer layer (LPL2, LPL3, LPL5) of the two outer layers (LPL2, LPL3, LPL5),
c) barrier regions (SB2...SB4) for the non-RF circuits and non-RF conductor-track structures (LBS2_{NHF}...LBS4_{NMF}) are arranged on the "micro via" layer (LPL1, LPL4, LPL6, MV1...MV3) and/or on the respective outer layer (LPL2, LPL3, LPL5) which is covered by the "micro via" layer such that the RF properties (FL3...FL5) of the RF circuits and RF conductor-track structures (LBS3_{RF}...LBS5_{RF}) which are arranged above and/or below the barrier regions (SB2...SB4) in relation to an RF earth layer (LPL3, MS4_{RF}...MS6_{RF}) of the support (LPT3...LPT5) are protected,
d) when the printed circuit board has components mounted, components of the RF/NRF circuits are arranged on the "micro via" layer (LPL1, LPL4, LPL6, MV1...MV3),
e) circuit interconnections (SVD2_{NRF}...SVD4_{NRF}) are arranged at least on the "micro via" layer (LPL1, LPL4, LPL6, MV1...MV3) and/or on the respective outer layer (LPL2, LPL3, LPL5) which is covered by the "micro via" layer (LPL1, LPL4, LPL6, MV1...MV3),
f) the conductor-track structures (LBS2_{NRF}...LBS4_{NRF}, LBS3_{RF}...LBS5_{RF}) are arranged at least on the "micro via" layer (LPL1, LPL4, LPL6, MV1...MV3) and/or on the respective outer layer (LPL2, LPL3, LPL5) which is covered by the "micro via" layer (LPL1, LBL4, LPL6, MV1...MV3).

2. Printed circuit board according to Claim 1,
**characterized in that**
the distance between the outer layer and the "micro via" layer is designed such that the "micro via" layer can be produced using the "Sequential Built Up" process (SBU process).

3. Printed circuit board according to Claim 1,
**characterized in that**
the distance between the outer layer and the "micro via" layer is designed such that the "micro via" layer can be produced by laser drilling using a CO₂ laser.

4. Printed circuit board according to Claim 1,
**characterized in that**
the distance between the outer layer and the "micro via" layer is designed such that the "micro via" layer can be produced using the "Silver Bump" process (SB process).

5. Printed circuit board according to Claim 2, 3 or 4, **characterized in that**
the distance between the outer layer and the "micro via" layer is 50 µm.

6. Printed circuit board according to one of Claims 1 to 5, **characterized in that**
first holes (DB1_{LPT4, 5}) are covered by the "micro via" layer without the barrier regions, and **in that** the RF circuit. and/or, for RF screening, a metal layer is applied to the "micro via" layer covering the first holes.

7. Printed circuit board according to Claim 6, **characterized in that**
the first holes are filled with a filling material (FM).

8. Printed circuit board according to one of Claims 1 to 7, **characterized in that**
the support is a multilayer support.

9. Printed circuit board according to Claim 8, **characterized in that**
the multilayer support is constructed using the Hybrid Masslan process.

10. Use of the printed circuit board according to one of Claims 1 to 9 in a DECT telecommunication appliance.

11. Use of the printed circuit board according to one of Claims 1 to 9 in a GSM telecommunication appliance.

12. Use of the printed circuit board according to one of Claims 1 to 9 in a PHS telecommunication appliance.

13. Use of the printed circuit board according to one of Claims 1 to 9 in an "IS-95" telecommunication appliance.

14. Use of the printed circuit board according to one of Claims 1 to 9 in a radio telecommunication appliance based on a pure or hybrid transmission method from the basic transmission methods FDMA, TDMA, CDMA.

## Revendications

1. Carte à circuits imprimés pour appareils électriques à constituants HF, en particulier, pour appareils mobiles de radiotélécommunication, des circuits HF, des circuits non-HF, des structures de pistes conductrices HF et des structures de pistes conductrices non-HF étant montées sur la carte à circuits imprimés (LP3, ..., LP5), avec les caractéristiques suivantes:
a) un support (LPT3, ..., LPT5) avec une première couche extérieure (LPL2) et une deuxième couche extérieure (LPL3, LPL5) comporte une pluralité de perforations (DB1_{LPT3,...,5}, DB2_{LPT3,...,5}) qui traversent les couches extérieures (LPL2, LPL3, LPL5),
b) une couche "micro via" (LPL1, LPL4, LPL6, MV1, ..., MV3) est appliquée au moins sur une couche extérieure (LPL2, LPL3, LPL5) des deux couches extérieures (LPL2, LPL3, LPL5), au moins sur une partie de sa (ou de leur) surface,
c) des zones de blocage (SB2, ..., SB4) pour les circuits non-HF et les structures de pistes conductrices non-HF (LBS2_{NHF} , ..., LBS4_{NHF}) sont disposées sur la couche "micro via" (LPL1, LPL4, LPL6, MV1, ..., MV3) et/ou sur la couche extérieure (LPL2, LPL3, LPL5) recouverte par la couche "micro via" de telle sorte que les propriétés HF (FL3, ..., FL5) des circuits HF et des structures de pistes conductrices non-HF (LBS3_{NHF}, ..., LBS5_{NHF}) disposés, par rapport à une couche de masse HF (LPL3, MS4_{HF}, ..., MS6_{HF}) du support (LPT3, ..., LPT5), au-dessus et/ou au-dessous des zones de blocage (SB2, ..., SB4), sont protégées,
d) sur la couche "micro via" (LPL1, LPL4, LPL6, MV1, ..., MV3) sont disposés, lorsque la carte à circuits imprimés est assemblée, des composants des circuits HF/non-HF,
e) des câblages (SVD2_{NHF}, ..., SVD4_{NHF}) sont disposés au moins sur la couche "micro via" (LPL1, LPL4, LPL6, MV1, ..., MV3) et/ou sur la couche extérieure (LPL2, LPL3, LPL5) recouverte par la couche "micro via" (LPL1, LPL4, LPL6, MV1, ..., MV3),
f) les structures de pistes conductrices non-HF (LBS2_{NHF}, ..., LBS4_{NHF}, LBS3_{HF}, ..., LBS5_{HF}) sont disposées au moins sur la couche "micro via" (LPL1, LPL4, LPL6, MV1, ..., MV3) et/ou sur la couche extérieure (LPL2, LPL3, LPL5) recouverte par la couche "micro via" (LPL1, LPL4, LPL6, MV1, ..., MV3).

2. Carte à circuits imprimés selon la revendication 1 **caractérisée par le fait que**
la distance entre la couche extérieure et la couche "micro via" est dimensionnée de telle sorte que la couche "micro via" peut être produite avec le procédé "**S**equential **B**uilt **U**p" (procédé SBU).

3. Carte à circuits imprimés selon la revendication 1 **caractérisée par le fait que**
la distance entre la couche extérieure et la couche "micro via" est dimensionnée de telle sorte que la couche "micro via" peut être produite par perçage par faisceau laser avec un laser au CO₂.

4. Carte à circuits imprimés selon la revendication 1 **caractérisée par le fait que**
la distance entre la couche extérieure et la couche "micro via" est dimensionnée de telle sorte que la couche "micro via" peut être produite avec le procédé "Silver Bump" (procédé SB).

5. Carte à circuits imprimés selon la revendication 2, 3 ou 4 **caractérisée par le fait que**
la distance entre la couche extérieure et la couche "micro via" est de 50 µm.

6. Carte à circuits imprimés selon l'une des revendications 1 à 5 **caractérisée par le fait que**
des premières perforations (DB1_{LPT4,5}) sont recouvertes par la couche "micro via" sans les zones de blocage et que le circuit HF et/ou une couche métallique destinée à l'écrantage HF sont disposés sur la couche "micro via" qui recouvre les premières perforations.

7. Carte à circuits imprimés selon la revendication 6 **caractérisée par le fait que**
les premières perforations sont comblées avec une matière de remplissage (FM).

8. Carte à circuits imprimés selon l'une des revendications 1 à 7 **caractérisée par le fait que**
le support est un support multicouche.

9. Carte à circuits imprimés selon la revendication 8 **caractérisée par le fait que**
le support multicouche est constitué selon le procédé Masslam hybride.

10. Utilisation de la carte à circuits imprimés selon l'une des revendications 1 à 9 dans un appareil de télécommunication DECT.

11. Utilisation de la carte à circuits imprimés selon l'une des revendications 1 à 9 dans un appareil de télécommunication GSM.

12. Utilisation de la carte à circuits imprimés selon l'une des revendications 1 à 9 dans un appareil de télécommunication PHS.

13. Utilisation de la carte à circuits imprimés selon l'une des revendications 1 à 9 dans un appareil de télécommunication "IS-95".

14. Utilisation de la carte à circuits imprimés selon l'une des revendications 1 à 9 dans un appareil de radiotélécommunication fonctionnant sur la base de procédés de transmissions pures ou hybrides des procédés de base de transmission FDMA, TDMA, CDMA.
